**Europäisches Patentamt**

(19) **European Patent Office**

**Office européen des brevets**

(11) Veröffentlichungsnummer: **0 115 565**
**B1**

(12) # EUROPÄISCHE PATENTSCHRIFT

(45) Veröffentlichungstag der Patentschrift:
14.12.88

(51) Int. Cl.⁴: **G 11 C 17/00,** G 01 G 23/37

(21) Anmeldenummer: 83108989.1

(22) Anmeldetag: 12.09.83

(54) **Verfahren zur Programmierung eines zu einem Messgerät gehörenden nichtflüchtigen Schreib-/Lesespeichers sowie Messgerät zur Durchführung des Verfahrens.**

(30) Priorität: 29.01.83 CH 494/83

(43) Veröffentlichungstag der Anmeldung:
15.08.84 Patentblatt 84/33

(45) Bekanntmachung des Hinweises auf die Patenterteilung:
14.12.88 Patentblatt 88/50

(84) Benannte Vertragsstaaten:
DE FR GB IT NL

(56) Entgegenhaltungen:
EP-A-0 024 436
GB-A-1 564 568

(73) Patentinhaber: Mettler Instrumente AG, Im Langacher, CH- 8606 Greifensee (CH)

(72) Erfinder: Bachmann, Rudolf, Breitistrasse 24, CH-8611 Bertschikon (CH)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Meßgerät, insbesondere Waage, mit einem durch Einlesen einer elektrischen Impulsfolge programmierbaren, nichtflüchtigen Schreib/Lesespeicher, in dem das Arbeitsprogramm des Meßerätes bestimmende Festwerte abgespeichert sind.

Seit einiger Zeit sind auf dem Markt nichtflüchtige Schreib/Lesespeicher als Speicherbauteile erhältlich, die beispielsweise unter den Bezeichnungen EAROM (electrically alterable read only memory) oder EEPROM (electrically erasable programmable read only memory) bekannt sind. Der Einfachheit halber sind jedoch in der folgenden Beschreibung alle derartigen Schreib/Lesespeicher ohne Beschränkung auf die speziellen Typen als EAROM bezeichnet.

Es wurde bereits die Verwendung derartiger nichtflüchtiger Schreib/Lesespeicher in einem Meßgerät der eingangs genannten Art vorgeschlagen, um dadurch die sonst sehr große Anzahl typenspezifischer oder gruppenspezifischer Nur-Lesespeicher (ROMs) erheblich herabzusetzen. In derartigen ROMs müssen die das Arbeitsprogramm des Meßgerätes bestimmenden Festwerte für jedes einzelne Meßgerät typenspezifisch oder gruppenspezifisch lange vor der tatsächlichen Verwendung durch Festprogrammierung festgelegt werden, wobei Änderungen nicht möglich sind. Derartige durch unterschiedliche Festwerte zu definierende Typenunterschiede sind beispielsweise bei Waagen die zulässige Anzeigeauflösung, die angezeigte Einheit, gewisse Umrechnungen, zusätzliche Funktionen wie Stillstandskontrolle, Wahl der Meßzeit u.dgl. Durch die bereits vorgeschlagene Verwendung der programmierbaren, nichtflüchtigen Schreib/Lesespeicher, die bei Bedarf entsprechend programmiert werden können, wird somit die anderenfalls sehr aufwendige Fabrikations- und Ersatzteillagerhaltung einer Vielfalt entsprechend vorprogrammierter Festwertspeicher vermieden.

Allerdings sind EAROMs gegenüber elektrischen Störimpulsen empfindlich, was selbst bei Anwendung von Schutzmaßnahmen, wie kapazitive Abschirmung, zu einem ungewollten Verlust oder einer Verfälschung der gespeicherten Daten führen kann. In diesem Fall muß das EAROM in dem Meßgerät, u.U. nach Ersatz durch ein neues, leeres EAROM, erneut mit den richtigen Festwerten geladen werden. Dabei können aber auch Verwechslungen auftreten, was zur Eingabe eines unzutreffenden Festwertsatzes führt.

Bei einer anderen bekannten Waage (DE-A-2 519 727) verursacht ein auf eine Waagschale aufgelegtes Gewicht eine relative Veränderung der Schwingungsfrequenzen zweier Meßzeiten. In einem Meßwertgeber wird ein dem Frequenzunterschied entsprechendes elektrisches Signal gebildet, das allerdings im allgemeinen keinen linearen Zusammenhang mit dem zu wiegenden Gewicht zeigt. Daher weist die bekannte Waage eine Recheneinrichtung auf, in der das Differenzfrequenzsignal gemäß einer vorgegebenen Polynomformel in den Gewichtswert umgerechnet wird. Hierzu ist es erforderlich, in der Recheneinrichtung die konstanten Polynomkooffizienten der vorgegebenen Polynomformel als Festwerte abzuspeichern. Zu diesem Zweck enthält die bekannte Waage nicht näher spezifizierte Festwertglieder, wobei offenbleibt, mit welchen Hilfsmitteln diese Festwertglieder erstmals eingestellt und nach Ersteinstellung nötigenfalls neu eingestellt oder umprogrammiert werden können, wie es beispielsweise bei einem durch Störungen hervorgerufenen Datenverlust erforderlich ist.

Dagegen wird bei einer anderen bekannten Waage (GB-A-1 564 568) durch optische Abtastung einer sich unter dem Einfluß eines zu wiegenden Gewichtes drehenden Codescheibe unmittelbar ein Binärsignal gewonnen, das ein lineares Maß für das Gewicht bildet. Eine Gewichtsumrechnung mit Hilfe vorgespeicherter Festwerte ist dabei also nicht erforderlich. Da diese bekannte Waage als automatische Portowaage ausgebildet ist, ist sie jedoch auch mit einem ROM-Speicher versehen, der die den einzelnen Gewichtsschritten und Versandklassen entsprechenden Portogebühren in fest vorprogrammierter Form enthält. Diese Speicher sind für alle einzelnen Waagen gleich und müssen lediglich bei Gebührenänderungen durch einen wiederum für alle Waagen einheitlichen ROM ausgewechselt werden.

Es ist auch eine Programmiereinrichtung für ein Gerät der Unterhaltungselektronik bekannt (EP-A-42 600), das dazu dient, beispielsweise ein bestimmtes Fernsehprogramm aufgrund vorgegebener Daten, wie Anfangszeit und Sendekanal des Fernsehprogramms, automatisch einzuschalten. Zur Eingabe dieser Daten ist die Programmiereinrichtung mit einer eine Abtasteinrichtung aufweisenden Lesestation versehen, durch die die Daten von einem Aufzeichnungsträger entnommen werden können, der beispielsweise in einer Fernsehprogramm-Zeitschrift abgedruckt ist. Dabei dient die Abtastung des Aufzeichnungsträgers zur Eingabe der veränderlichen, benutzerseitigen Daten für den bestimmungsgemäßen Gebrauch der Programmiereinrichtung, wogegen eine Eingabe und Sicherung permanenter Betriebsdaten durch den Aufzeichnungsträger weder vorgesehen noch nötig ist.

Schließlich ist eine Programmierschaltung für ein EPROM bekannt (EP-A-24 436), in der mittels eines Oszillator 29 nachgeschalteten Binärzählers die zur Programmierung erforderliche elektrische Impulsfolge erzeugt wird. Die einzuschreibenden Daten werden dabei von einem optisch abtastbaren Informationsträger abgelesen und in einem RAM-Speicher der Programmierschaltung zwischengespeichert. Nach fertiger Programmierung wird das EPROM aus dem Programmiergerät entnommen, um in anderen Geräten für einen Nur-Lese-Gebrauch eingesetzt zu werden.

Der Erfindung liegt die Aufgabe zugrunde, ein Meßgerät der eingangs genannten Art dahingehend auszubilden, daß auf einfache und verwechslungssichere Weise eine Reprogrammierung des in dem Meßgerät vorgesehenen nichtflüchtigen Schreib/Lesespeichers möglich ist.

Diese Aufgabe wird erfindungsgemäß dadurch gelöst, daß an dem Meßgerät die Festwerte ein zweites Mal in abtastbarer Form auf einem für eine direkte Zuordnung der Festwerte zum Meßgerät an dem Meßgerät fest angeordneten zusätzlichen Informationsträger vorhanden und mittels einer Abtasteinrichtung abnehmbar sowie in den Schreib/Lesespeicher übertragbar sind.

Bei der Erfindung sind also die das Arbeitsprogramm bestimmenden Festwerte nicht nur in dem für den Betrieb des Meßgerätes erforderlichen Schreib/Lesespeicher, der störanfällig ist, abgespeichert, sondern auch noch ein weiteres Mal an dem Meßgerät selbst auf dem zusätzlichen Informationsträger. Letzterer ist zwar nicht wie der Schreib/Lesespeicher adressierbar und damit als Arbeitsspeicher ungeeignet, hat aber die Eigenschaften hoher Störungssicherheit und geringer Kosten. Damit sind die Festwerte an dem Meßgerät störungssicher konserviert und können mittels der Abtasteinrichtung im Bedarfsfall leicht und verwechslungsfrei in den als Arbeitsspeicher dienenden Schreib/Lesespeicher neu eingegeben werden.

Eine besonders einfach zu realisierende Ausführungsform der Erfindung zeichnet sich dadurch aus, daß der Informationsträger in ein Gehäuse des Meßgerätes eingeklebt ist.

Der Informationsträger kann durch einen Papierstreifen gebildet sein. Alternativ ist es aber auch möglich, den Informationsträger in der Form einer Magnetkarte auszubilden.

Vorzugsweise sind die Festwerte auf dem Informationsträger in der Form eines Strichcodes aufgezeichnet. Hierbei wird die vorgegebene Impulsfolge durch optische Abtastung des Strichcodes mit Hilfe eines Strichcodelesers gewonnen. Der Strichcode ist störungsunempfindlich und beispielsweise auf Papier oder Folie durch Drucken leicht und dauerhaft herstellbar. Zur Überprüfung einer korrekten Programmierung können auf einer Sichtanzeige des Meßgerätes Kontrollangaben über die jeweils eingelesenen Impulsfolgen sichtbar gemacht werden. Damit kann insbesondere im Falle des Strichcodes sofort erkannt werden, wenn beispielsweise ein Teil des Codes irrtümlich nicht abgetastet wurde.

Schließlich erweist sich eine weitere Ausgestaltung der Erfindung als besonders zweckmäßig, bei der mehrere zusätzliche Informationsträger mit verschiedenen Sätzen von Festwerten vorgesehen sind. Damit kann beispielsweise bei einer Waage der eine Festwertsatz das normale Arbeitsprogramm und der andere ein Wartungsprogramm festlegen. Durch temporäres Umprogrammieren des EAROM für Wartungsarbeiten (z. B. Kontrollen oder Nacheinstellungen), kann somit das Verhalten der Waage nötigenfalls verändert werden, beispielsweise um gewisse Funktionen aus- und andere einzuschalten. Am Ende der Wartung kann sodann durch einfaches Abtasten des dem normalen Arbeitsprogramm entsprechenden Informationsträgers wieder auf das normale Arbeitsverhalten zurückprogrammiert werden.

Ein Ausführungsbeispiel der Erfindung wird im folgenden anhand der schematischen Zeichnung erläutert, in welcher

Figur 1 eine Waage, und
Figur 2 eine Programmierschaltung

darstellen.

Die Waage 10 umfasst in bekannter Weise ein Gehäuse 12. In dieses sind innen zwei Papieretiketten 14 und 16 eingeklebt. Beide Etiketten sind mit einem Streifen- oder Strichcode (bar code) bekannter Art bedruckt, wobei das Etikett 14 den Code für das normale Arbeitsprogramm der Waage enthält, das Etikett 16 hingegen einen Code für ein für Wartungs- und Kontrollzwecke geändertes Programm. Beide Etiketten sind zur visuellen Identifizierung mit entsprechenden Bezeichnungen versehen, das Etikett 16 beispielsweise mit der Typenbezeichnung A 3. Das nachgestellte S bedeutet "Service", d. h. das entsprechende Programm ist (nur) für Wartungszwecke.

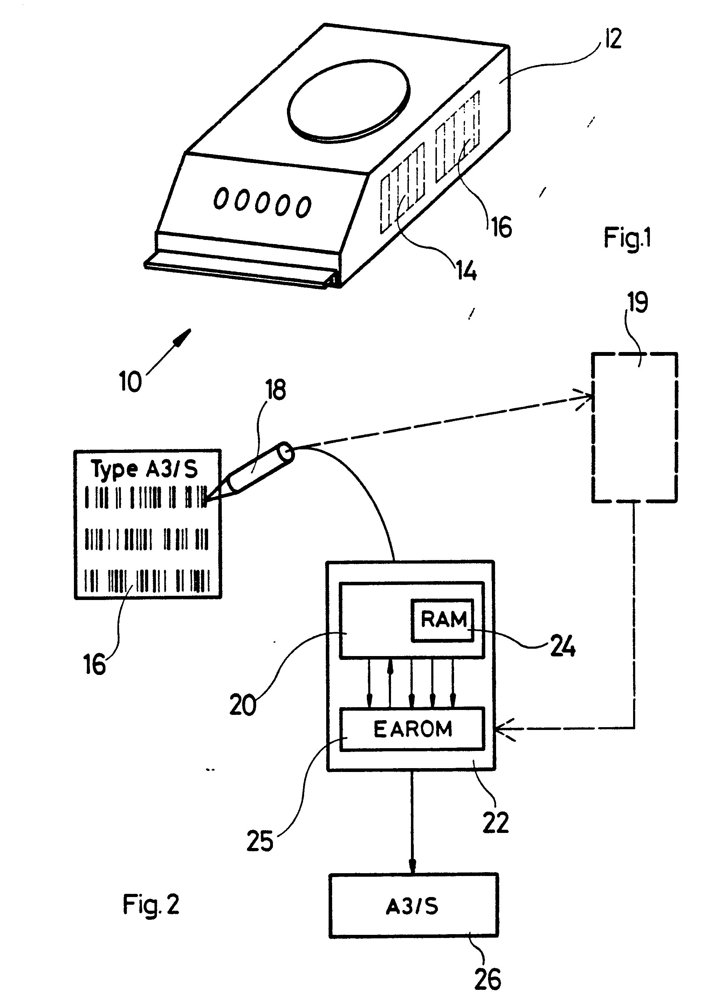

Figur 2 verdeutlicht einen Anwendungsfall. Anlässlich eines Kundendienstes wird mittels eines Codelesestiftes (Strichcodelesers) 18 der Code für die Wartung abgetastet (Etikett 16), d.h. die Waage 10 arbeitet danach in einigen Funktionen anders als im normalen Wägebetrieb (das Etikett 16 ist zwar in Figur 2 separat gezeichnet, es verbleibt in Wirklichkeit aber im Gehäusedeckel 12).

Der Codelesestift 18 kann beispielsweise vom Typ HP HEDS 3000 (Firma Hewlett Packard) sein. Er liefert die vom Etikett 16 abgetasteten Signale in TTL-Form an das Ein-Chip-Mikroprozessor-System 20 der Waagenelektronik 22. Der Mikroprozessor 20 sammelt die erhaltenen Informationen, kontrolliert sie und speichert sie in einem Zwischenspeicher (RAM) 24. Nach beendeter Abtastung des Etiketts 16 und erfolgter Kontrolle wird der Inhalt des RAM 24 in das EAROM 25 eingeschrieben; dieses ist damit (neu oder um-) programmiert.

Zur Kontrolle für den Wartungstechniker erscheint dabei in der Waagenanzeige 26 zunächst die Bestätigung 'A 3 / S', sodann, nach jeder Codezeile, als Aufforderung die Nummer der nächsten zu lesenden Zeile aus dem Etikett 16. Wurde eine Zeile ganz oder teilweise ausgelassen, so erscheint in der Anzeige 26 'Error'. Dies wird erreicht durch eine entsprechende Kombination von Prüfziffern aus den einzelnen Codezeilen.

Nach abgeschlossener Wartung wird das EAROM 24 durch Lesen des Codes des Etiketts 14 wieder in den normalen Wägemodus zurückprogrammiert. Dasselbe gilt für den Fall, dass ein EAROM nach einer Störung wieder korrigiert oder aber ein defektes gegen ein neues (noch unprogrammiertes) EAROM ausgetauscht werden muss.

Bekannte Strichcodes sind beispielsweise der UPC- oder der EAN-Code, ferner der Code 39 oder ein 2-aus-5-Code. Je nach Art des Gerätes wird man einen optimal geeigneten Code auswählen.

Unter den im Rahmen der Erfindung möglichen Variationen seien als Beispiele angeführt:

- Anordnung des Informationsträgers in einem beliebigen Teil eines mehrteiligen Systems (z. B. aus Wägeplattform und separater Anzeige oder, im Falle eines anderen Messgerätes, aus Messteil und Steuerteil bestehend);
- Anordnung des Informationsträgers aussen, falls ein Öffnen des Gerätes oder Geräteteils nicht zweckmässig erscheint;
- Anordnung mehrerer typenspezifischer Informationsträger im Rahmen eines Gerätes oder Systems, sofern es die Art der Typenunterschiede erlaubt; dies gestattet eine nachträgliche Umprogrammierung derart, dass z. B. eine in Gramm anzeigende Waage in eine Karatwaage verwandelt wird;
- Lesen des Etiketts und (Um-)Programmieren des EAROMs mit Hilfe einer dem Strichcodeleser 18 zugeordneten eigenen, mikroprozessorgesteuerten Programmierschaltung 19. Dies kann z. B. dann erforderlich sein, wenn das Mikroprozessorsystem 20 der Waagenelektronik 22 zu wenig Speicherkapazität hat. In diesem Falle würden die abgetasteten, aufbereiteten und kontrollierten Daten direkt dem EAROM 25 eingeschrieben. Diese Variante ist in Figur 2 gestrichelt angedeutet.

Ferner sei der Vollständigkeit halber erwähnt, dass die (Neu- oder Um-)Programmierung des hier bevorzugten EAROMs jeweils die ganze oder aber nur einen Teil der Speicherkapazität betreffen kann. Schliesslich sei nochmals betont, dass die Erfindung sich ausser auf Waagen auch auf andere Messgeräte bezieht, wie z. B. Titratoren, pH-Messgeräte, Digitalvoltmeter, Geräte auf dem Gebiet der Thermoanalyse und andere mehr.

**Patentansprüche**

1. Meßgerät, insbesondere Waage, mit einem durch Einlesen einer elektrischen Impulsfolgeprogrammierbaren, nichtflüchtigen Schreib/Lesespeicher (25), in dem das Arbeitsprogramm des Meßgerätes (10) bestimmende Festwerte abgespeichert sind, dadurch gekennzeichnet, daß die Festwerte ein zweites Mal in abtastbarer Form auf einem für eine direkte Zuordnung der Festwerte zum Meßgerät (10) an dem Meßgerät (10) fest angeordneten, zusätzlichen Informationsträger (14, 16) vorhanden und mittels einer Abtasteinrichtung (18) abnehmbar sowie in den Schreib/Lesespeicher (25) übertragbar sind.

2. Meßgerät nach Anspruch 1, dadurch gekennzeichnet, daß der Informationsträger (14, 16) in ein Gehäuse (12) des Meßgerätes eingeklebt ist.

3. Meßgerät nach Anspruch 1 oder 2, dadurch gekennzeichnet, daß der Informationsträger (14, 16) durch eine Magnetkarte gebildet ist.

4. Meßgerät nach Anspruch 1 oder 2, dadurch gekennzeichnet, daß der Informationsträger (14, 16) durch einen Papierstreifen gebildet ist.

5. Meßgerät nach einem der Ansprüche 1 bis 4, dadurch gekennzeichnet, daß die Festwerte auf dem Informationsträger (14, 16) in der Form eines Strichcodes aufgezeichnet sind.

6. Meßgerät nach einem der Ansprüche 1 bis 5, dadurch gekennzeichnet, daß mehrere zusätzliche Informationsträger (14, 16) mit verschiedenen Sätzen von Festwerten vorgesehen sind.

7. Meßgerät nach einem der Ansprüche 1 bis 6, dadurch gekennzeichnet, daß das Meßgerät einen Mikroprozessor (20) mit einem Speicher (24) mit wahlfreiem Zugriff aufweist, in dem die durch die Abtasteinrichtung (18) von dem zusätzlichen Informationsträger (14, 16) abgenommenen Festwerte zwischengespeichert werden.

8. Meßgerät nach einem der Ansprüche 1 bis 6, dadurch gekennzeichnet, daß für die Abtasteinrichtung (18) eine von dem Meßgerät (10) getrennte mikroprozessorgesteuerte Programmierschaltung (19) vorgesehen ist.

**Claims**

1. A measuring apparatus, in particular a weighing machine, comprising a non-volatile write/read memory (25) which can be programmed by reading in an electrical pulse train and in which fixed values determining the working program of the measuring apparatus (10) are stored, characterised in that the fixed values are present a second time in scanable form on an additional information carrier (14, 16) which is fixedly arranged on the measuring apparatus (10) for direct association of the feed values with the measuring apparatus (10), and can be picked up by means of a scanning device (18) and transferred into the write/read cry (25).

2. A measuring apparatus according to claim 1 characterized in that the information carrier (14, 16) is glued into a housing (12) of the measuring apparatus.

3. A measuring apparatus according to claim 1 or claim 2 characterized in that the information carrier (14, 16) is formed by a magnetic card.

4. A measuring apparatus according to claim 1 or claim 2 characterized in at the information carrier (14, 16) is formed by a paper strip.

5. A measuring apparatus according to one of claims 1 to 4 characterised in that the feed values are recorded on the information carrier (14, 16) in the form of a bar code.

6. A measuring apparatus according to one of claims 1 to 5 characterised in that there are provided a plurality of additional information carriers (14, 16) with different sets of fixed values.

7. A measuring apparatus according to one of claims 1 to 6 characterised in that the measuring apparatus has a microprocessor (20) with a random access cry (24) in which the feed values picked up by the scanning device (18) from the additional information carrier (14, 16) are put into intermediate storage.

8. A measuring apparatus according to one of claims 1 to 6 characterized in that a microprocessor-controlled programming circuit (19) which is separate from the measuring apparatus (10) is provided for the scanning device (18).

**Revendications**

1. Instrument de mesure, notamment balance, présentant une mémoire à écriture/lecture (25) non volatile, pouvant être programmée par entrée d'un train d'impulsions électriques, et dans laquelle sont mémorisées des valeurs constantes déterminant le programme de travail de l'instrument de mesure (10), caractérisé par le fait que les valeurs constantes sont présentes une seconde fois sous forme explorable, sur un support d'informations supplémentaire (14, 16) qui est installé fixement sur l'instrument de mesure (10), en vue d'une assignation directe des valeurs constantes à cet instrument de mesure (10), et peuvent être prélevées au moyen d'un dispositif d'exploration (18), puis transférées dans la mémoire à écriture/lecture (25).

2. Instrument de mesure selon la revendication 1, caractérisé par le fait que le support d'informations (14, 16) est collé à l'intérieur d'un boîtier (12) de l'instrument de mesure.

3. Instrument de mesure selon la revendication 1 ou 2, caractérisé par le fait que le support d'informations (14, 16) est formé par une carte magnétique.

4. Instrument de mesure selon la revendication 1 ou 2, caractérisé par le fait que le support d'informations (14, 16) est formé par une bande de papier.

5. Instrument de mesure selon l'une des revendications 1 à 4, caractérisé par le fait que les valeurs constantes sont inscrites sur le support d'informations (14, 16) sous la forme d'un code à barres.

6. Instrument de mesure selon l'une des revendications 1 à 5, caractérisé par le fait que plusieurs supports d'informations supplémentaires (14, 16) sont prévus, avec différents jeux de valeurs constantes.

7. Instrument de mesure selon l'une des revendications 1 à 6, caractérisé par le fait que cet instrument de mesure présente un microprocesseur (20) avec une mémoire (24) à accès sélectif, dans laquelle les valeurs constantes, prélevées du support d'informations supplémentaire (14, 16) par l'intermédiaire du dispositif d'exploration (18), font l'objet d'une mémorisation intermédiaire.

8. Instrument de mesure selon l'une des revendications 1 à 6, caractérisé par le fait qu'un circuit de programmation (19), commandé par microprocesseur et séparé de l'instrument de mesure (10), est prévu pour le dispositif d'exploration (18).

Fig.1

Type A3/S

Fig. 2